# FASCICULE DE BREVET EUROPEEN

(11) **EP 3 394 982 B1**
(45) Date de publication et mention de la délivrance du brevet: **08.09.2021**
(21) Numéro de dépôt: 16826413.3
(22) Date de dépôt: 20.12.2016
(51) Int. Cl.: H03K 17/16, H02M 1/08, H02M 1/32

(54) **DISPOSITIF DE COMMANDE D'UN TRANSISTOR EN COMMUTATION ET SON UTILISATION DANS UN MODULE ELECTRONIQUE DE PUISSANCE D'UN VEHICULE AUTOMOBILE**
VORRICHTUNG ZUR SCHALTSTEUERUNG EINES TRANSISTORS UND DEREN VERWENDUNG IN EINEM LEISTUNGSELEKTRONIKMODUL EINES KRAFTFAHRZEUGS
DEVICE FOR CONTROLLING THE SWITCHING OF A TRANSISTOR AND ITS USE IN A POWER ELECTRONIC MODULE OF AN AUTOMOTIVE VEHICLE

(30) Priorité: 21.12.2015 FR 1562950
(43) Date de publication de la demande: 31.10.2018
(73) Titulaire: Valeo Equipements Electriques Moteur, 94046 Créteil Cedex (FR)
(72) Inventeur: SARDAT, Pierre, 93340 Le Raincy (FR)
(74) Mandataire: Valeo Powertrain Systems
(86) Numéro de dépôt international: PCT/FR2016/053577
(87) Numéro de publication internationale: WO 2017/109385

(56) Documents cités:
- EP-A1- 2 418 776
- EP-A2- 0 687 056
- WO-A1-2012/087320
- GB-A- 2 493 562
- JP-A- 2000 134 075

## Description

### DOMAINE TECHNIQUE DE L'INVENTION.

L'invention concerne le domaine de l'électronique de puissance pour l'automobile et en particulier un dispositif de commande d'un transistor en commutation, et son utilisation dans un module électronique de puissance d'un véhicule automobile.

### ARRIERE PLAN TECHNOLOGIQUE DE L'INVENTION.

Il est connu en soi que dans des circuits où les transistors fonctionnent en commutation, il peut y avoir des risques de surtension à cause des variations rapides des courants commutés dans des charges inductives ou dans des inductances parasites, internes ou externes aux transistors, conduisant dans certains cas à une dégradation, voire à une destruction de l'élément de commutation à semi-conducteur par effet d'avalanche.

Afin de pallier ces risques, diverses solutions sont bien connues de l'état de la technique.

Une première solution consiste en une limitation d'une dérivée temporelle di/dt du courant commuté induite par une limitation d'une dérivée temporelle dv/dt d'une tension commutée grâce à une résistance placée en série avec la grille des IGBT (acronyme de "Insulated Gate Bipolar Transistor" en terminologie anglo-saxone, c'est-à-dire "Transistor Bipolaire à Grille Isolée") et des MOSFET (acronyme de "Metal Oxide Semiconductor Field Effet Transistor", c'est-à-dire "Transistor à Effet de Champ à Semiconducteur Métal Oxyde"). Cette première solution est très bon marché, mais pas assez efficace pour les applications de forte puissance.

Une deuxième solution consiste à limiter directement les pics de tensions grâce à l'addition d'un circuit supplémentaire: circuit amortisseur dit "snubber", circuit RCD (résistance- capacité- diode), etc...Cette deuxième solution est efficace, mais elle est onéreuse, diminue le rendement, et n'est pas toujours applicable dans les applications de puissance.

Une troisième solution consiste à limiter la dérivée temporelle di/dt en contrôlant une tension aux bornes d'une inductance parasite entre la source des MOSFET, ou l'émetteur des IGBT, et la masse du circuit de puissance. Cette troisième solution est aussi complexe, et délicate à appliquer dans des éléments intégrés (modules de puissance, circuits en technologie DBC (acronyme de "Direct Bonded Copper", c'est-à-dire "Cuivre Directement Collé"), IML (acronyme de "Insulated Metal Leadframe", c'est-à-dire "Trace de Puissance Métallique Isolée"), IMS (acronyme de "Insulated Metal Subtrate", c'est-à-dire "Substrat Métallique Isolé"), etc ...).

Une quatrième solution consiste à limiter la dérivée temporelle di/dt en limitant la dérivée temporelle dv/dt des tensions de commande des IGBT et MOSFET. Cette quatrième solution est très complexe à mettre en œuvre, et nécessite l'introduction de composants entre une connexion de masse du circuit de commande et une masse du circuit de puissance.

Une autre solution décrite dans la demande brevet FR2993422 de la société VALEO SYSTEMES DE CONTRÔLE MOTEUR pour réduire la dérivée temporelle di/dt consiste à injecter un courant auxiliaire s'opposant au courant de commande dans la grille du MOSFET ou de l'IGBT. Cette autre solution est également très complexe à mettre en œuvre, et nécessite l'introduction de nombreux composants supplémentaires dans un circuit de commande auxiliaire.

Une autre solution définie dans le préambule de la evendication 1 est divulguée dans le document EP 0 687 056 A2. Au vu de ces diverses solutions connues qui ne donnent pas entière satisfaction, il existe donc un besoin pour en supprimer les inconvénients, ou du moins, les atténuer.

### DESCRIPTION GENERALE DE L'INVENTION.

La présente invention vise donc un dispositif de commande d'un transistor en commutation, comprenant:
- le transistor comportant une électrode de commande et des électrodes de puissance;
- un circuit de commande relié à cette électrode de commande;
- des moyens de limitation d'une dérivée temporelle d'un courant de puissance circulant entre ces électrodes de puissance.

Selon l'invention, ces moyens de limitation asservissent une tension de mesure proportionnelle à cette dérivée temporelle à une tension de référence prédéterminée en appliquant une tension d'erreur sur l'électrode de commande.

La tension d'erreur est amplifiée selon l'invention par un gain intrinsèque du transistor en mode linéaire.

Selon l'invention encore, la tension de référence est supérieure ou égale à une tension de seuil de conduction du transistor.

Dans le dispositif de commande d'un transistor en commutation selon l'invention, les moyens de limitation comprennent une première inductance, reliée à une première électrode des électrodes de puissance et parcourue par le courant de puissance, couplée magnétiquement négativement à une seconde inductance, insérée en série entre le circuit de commande et l'électrode de commande, et fournissant à ses bornes une partie de la tension de mesure.

Selon l'invention, une limitation de la dérivée temporelle est donnée par l'expression Vref/L1, où Vref est la tension de référence et L1 une valeur d'inductance de la première inductance.

Dans le dispositif de commande d'un transistor en commutation selon l'invention, les moyens de limitation comprennent en outre une source de tension continue présentant une tension nominale prédéterminée insérée en série entre le circuit de commande et la seconde inductance de telle sorte que la tension de référence est égale à une somme de la tension de seuil et de cette tension nominale.

Selon l'invention, la source de tension est formée par un nombre prédéterminé de diodes identiques en série polarisées dans un sens direct par le circuit de commande dans un état "haut", de telle sorte que la tension nominale est égale à une tension de coude des diodes multipliée par ce nombre.

Dans le dispositif de commande d'un transistor en commutation selon l'invention, les moyens de limitation comprennent en outre un condensateur en parallèle sur ces diodes et chargé dans un circuit de charge comprenant au moins une résistance.

Selon l'invention, la première inductance et la seconde inductance constituent respectivement un primaire et un secondaire d'un transformateur planaire sans noyau magnétique formé au voisinage du transistor dans une couche métallique d'un circuit imprimé ou sur un substrat de type DBC, IML, ou IMS.

Un rapport de transformation de ce transformateur est, selon l'invention, supérieur ou égal à deux.

Dans le dispositif de commande d'un transistor en commutation selon l'invention, le transistor est de type MOSFET et:
- l'électrode de commande est une grille du transistor;
- la première électrode de puissance est une source de ce transistor et une seconde électrode des électrodes de puissance est un drain de ce transistor. Alternativement, le transistor est de type IGBT et:
- l'électrode de commande est une grille du transistor;
- la première électrode de puissance est un émetteur de ce transistor et une seconde électrode des électrodes de puissance est un collecteur de ce transistor.

L'invention concerne aussi une utilisation du dispositif de commande décrit ci-dessus dans un module de puissance de véhicule automobile comprenant au moins un transistor en commutation. Un tel module de puissance peut être compris par exemple dans un dispositif de redressement synchrone, un onduleur, un convertisseur courant continu- courant continu, un convertisseur courant continu - courant alternatif réversible, un régulateur d'excitation ou un dispositif de commande de démarreur.

Ces quelques spécifications essentielles auront rendu évidents pour l'homme de métier les avantages du dispositif de commande d'un transistor en commutation selon l'invention par rapport à l'état de la technique.

Les spécifications détaillées de l'invention sont données dans la description qui suit en liaison avec le dessin ci-annexé. Il est à noter que ce dessin n'a d'autre but que d'illustrer le texte de la description et ne constitue en aucune sorte une limitation de la portée de l'invention.

### BREVE DESCRIPTION DU DESSIN.

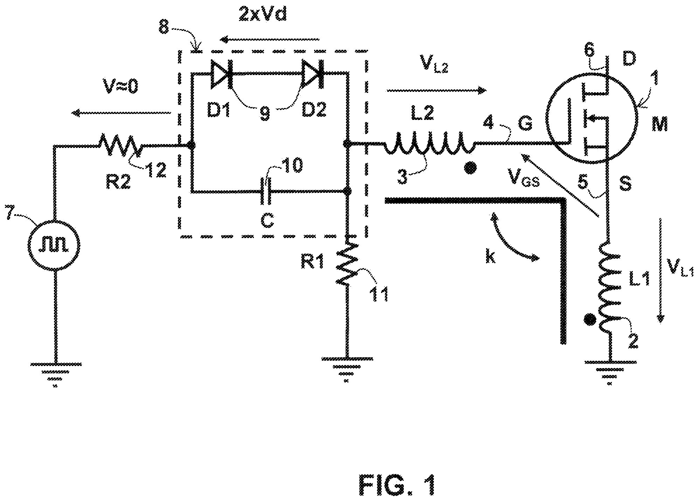

La **Figure 1** est un schéma de principe simplifié d'un mode de réalisation préféré du dispositif de commande d'un transistor en commutation selon l'invention.

### DESCRIPTION DES MODES DE REALISATION PREFERES DE L'INVENTION.

La solution de limitation de la dérivée temporelle di/dt dont le schéma de principe est donné sur la **Figure 1** est similaire à certaines solutions connues de l'état de la technique, mais sans boucle de rétroaction matérielle à haute vitesse supplémentaire, difficile à réaliser, et ne nécessite pas de composants supplémentaires sur les substrats DBC, IML ou IMS des modules de puissance.

Le principe général de l'invention est d'utiliser le très grand produit gain - bande passante intrinsèque d'un transistor de type MOSFET 1 quand il fonctionne en mode linéaire, de manière à apporter le gain nécessaire de la boucle di/dt avec le retard de phase le plus petit possible dans la fonction de transfert en boucle ouverte.

C'est pourquoi la solution proposée par l'entité inventive est implémentée au voisinage du MOSFET, et peut être considérée comme une solution MOSFET "locale", de manière à minimiser la taille (et les délais dus au câblage parasite) de la boucle. C'est aussi la raison pour laquelle, par comparaison aux solutions connues de l'état de la technique, tous les composants supplémentaires ajoutés à la boucle de rétroaction sont supprimés, et remplacés par le gain intrinsèque du transistor MOSFET 1 commandé.

Dans le mode de réalisation préféré de l'invention, un couplage magnétique négatif entre des première et seconde inductances 2, 3 sans noyau magnétique est introduit entre une électrode de grille 4 et une électrode de source 5 d'un MOSFET 1 (canal N), de manière très proche du composant 1 lui-même (en boîtier, ou dans une configuration de puce nue), pour fermer la boucle de rétroaction. Bien entendu, d'autres formes de réalisation de l'invention pourront faire appel à un transistor MOSFET 1 de type canal P à la place du transistor MOSFET 1 de type canal N indiqué plus haut.

Le capteur est formé par l'inductance parasite 2 du câblage de l'électrode de source 5. La tension de référence de la boucle est la tension de seuil de conduction V_{GS}(th) du transistor MOSFET 1 à laquelle s'ajoutera la tension aux bornes du condensateur 10, en parallèle avec les deux diodes en série D1, D2, dans le cas où l'amélioration décrite par la suite et incorporant le circuit 8 montré à la **Figure 1** est implémentée dans le dispositif selon l'invention.

Une variation di/dt du courant de puissance i(t) circulant entre l'électrode de drain 6 et l'électrode de source 5 génère une surtension V_{L1} aux bornes de la première inductance 2, quand le transistor MOSFET 1 est commuté dans un état "bloqué" par un état "bas" d'une commande d'un circuit de commande 7. On notera que la variation di/dt peut être à l'origine, dans l'état de la technique, c'est-à-dire dans un circuit ne comprenant pas les moyens prévus dans la présente invention, d'un claquage du transistor 1 par effet d'avalanche du fait qu'elle se produit également dans les inductances parasites de drain/source du MOSFET 1 (ou dans les inductances parasites de collecteur/émetteur dans le cas d'un transistor IBGT).

Dans cette forme de réalisation, le coefficient de couplage k entre la première inductance 2 et la seconde 3 est de l'ordre de 0,45 à 0,55 en valeur absolue. Un rapport de transformation de l'ordre de deux est choisi pour éviter une connexion de puissance trop longue de l'électrode de source 5 (de manière à réduire une résistance parasite et à gagner de la place au moment du routage sur le support (technologie PCB, DBC, IML ou autres), pour une même efficacité. De manière générale, le rapport de transformation sera au moins égal à deux dans la plupart des applications de l'invention, mais pourra être très sensiblement supérieur à deux dans certains cas.

La tension de mesure V_{L2} générée aux bornes de la seconde inductance 3 est ainsi proportionnelle à la dérivée temporelle di/dt du courant de puissance i(t). La tension de mesure V_{L1}+V_{L2} est comparée à la tension de référence, et une tension d'erreur est appliquée directement sur l'électrode de grille 4 du MOSFET 1, qui amplifie cette différence et rend la dérivée temporelle di/dt égale à Vref/L1, Vref étant la tension de référence et L1 étant une valeur d'inductance de la première inductance 2.

En variante, une importante amélioration a été apportée par l'entité inventive au fonctionnement de base décrit ci-dessus.

Une source de tension continue 8 relativement stable est appliquée en série entre le circuit de commande 7 et une connexion de commande de l'électrode de grille 4 du MOSFET 1, de manière à réduire une influence d'une dispersion importante de la tension de seuil V_{GS}(th) (due aux dispersions des caractéristiques du MOSFET en production et aux effets de la température) sur la tension de référence Vref.

Cette source de tension 8 ayant une tension nominale prédéterminée est formée par deux diodes 9 identiques présentant une tension de coude Vd (de l'ordre de 0,55 V pour une diode de commutation au silicium) polarisées dans le sens direct par le circuit de commande 7 dans un état "haut", de sorte que la tension de référence Vref est donnée dans cette variante par l'expression Vref = V_{GS}(th) + 2 x Vd.

Le condensateur 10 connecté en parallèle sur ces diodes 9 est nécessaire pour maintenir la tension nominale 2 x Vd quand le circuit de commande 7 est dans un état "bas", mais aussi pour fournir une part significative d'un courant de grille pendant les commutations.

La source de tension 8 est aussi une source de tension négative gratuite appliquée entre l'électrode de grille 4 et l'électrode de source 5 (de l'ordre de 1,1 V), qui améliore le blocage du MOSFET 1 dans l'état "bloqué".

Ce condensateur est chargé par un circuit de charge comprenant une première résistance 11 dans l'état "haut" du circuit de commande 7. Cette première résistance 11 force également le MOSFET 1 dans l'état "bloqué" quand le circuit de commande 7 n'est pas actif.

Une seconde résistance 12 en série dans le circuit de charge 7, 11, 12 est également nécessaire pour régler des temps de commutation en tension. Une autre tension V aux bornes de cette seconde résistance 12 est considérée comme négligeable par rapport à la tension nominale 2 x Vd de la source de tension 8.
On notera ici que le fait de régler des temps de commutation en tension est un avantage important par rapport aux solutions connues de la technique antérieure dans lesquelles on souhaite limiter le di/dt pour des raisons de sécurité, vis-à-vis d'une possible avalanche. En effet, avec la solution de l'invention présentée ci-dessus, il devient possible de régler séparément les temps de commutation en tension (grâce à la résistance 12) et en courant (grâce au contrôle du di/dt). Il est ainsi possible de trouver un compromis sur la somme des temps de commutation, en tension et en courant, permettant de ne pas augmenter les pertes par commutation dues aux deux types de commutation, et même éventuellement de faire décroître celles-ci par exemple en réduisant le temps de commutation en tension et en augmentant le temps de commutation en courant. Dans un mode de réalisation concret de la présente invention sur un circuit imprimé, ou dans un module électronique de puissance en technologie DBC, IML ou IMS, les première et seconde inductances 2, 3 prennent la forme d'un transformateur planaire sans noyau magnétique formé directement dans une couche métallique, au plus près du MOSFET 1 au niveau des électrodes de drain et de source 5, 6.

Un avantage de cette structure, comparée à un écrêtage actif classique, est qu'il n'est pas nécessaire de prévoir une connexion supplémentaire pour capter une tension de drain. Par exemple, dans un écrêtage actif pour un onduleur triphasé, six éléments de commutation à semi-conducteur 1 doivent être pris en considération. Par conséquent, six connexions supplémentaires seraient nécessaires pour réaliser la fonction d'écrêtage, alors qu'il n'y en a aucun avec la solution de l'invention.

En termes de coût, avec la solution de l'invention, on n'a pas besoin d'ajouter sur le substrat (au voisinage des éléments de commutation de puissance 1) des circuits RCD, ou des circuits "snubber", onéreux, fragiles et complexes, parce qu' on réalise un amortissement des oscillations parasites, et une dissipation complète des pertes engendrées par des courants de rupture, par le MOSFET 1 lui-même en mode linéaire.

Comme il va de soi, l'invention ne se limite pas aux seuls modes d'exécution préférentiels décrits ci-dessus.

Notamment, le type de transistor de puissance 1 cité n'est pas limitatif; l'utilisation d'autres éléments à semi-conducteurs susceptibles de réaliser les mêmes fonctions qu'un MOSFET 1, par exemple un transistor de type IGBT, ne sortirait pas du cadre de l'invention.

La source de tension continue 8 pourrait être formée d'un nombre de diodes 9 en série différent de deux, ou de diodes 9 d'un type différent de celui cité, par exemple des diodes Zéner.

De manière générale, l'homme de métier pourra autant que de besoin implémenter les mêmes fonctions à moindre coût avec des éléments passifs ou actifs, discrets, pour montage en surface, ou hybrides, différents de ceux décrits 1, 2, 3, 9, 10, 11, 12.

L'invention embrasse toutes les variantes possibles de réalisation dans la limite de l'objet des revendications ci-après.

## Revendications

1. Dispositif de commande d'un transistor (1) en commutation, comprenant:
- ledit transistor (1) comportant une électrode de commande (4) et des électrodes de puissance (5, 6);
- un circuit de commande (7) relié à ladite électrode de commande (4);
- des moyens de limitation (2, 3, 8) d'une dérivée temporelle d'un courant de puissance (i(t)) circulant entre lesdites électrodes de puissance (5, 6),
lesdits
moyens de limitation (2, 3, 8) asservissent une tension de mesure (V_{L2}) proportionnelle à ladite dérivée temporelle à une tension de référence prédéterminée en appliquant une tension d'erreur sur ladite électrode de commande (4), ladite tension d'erreur est amplifiée par un gain intrinsèque dudit transistor (1) en mode linéaire, ladite tension de référence est supérieure ou égale à une tension de seuil de conduction dudit transistor (1),
lesdits moyens de limitation (2, 3, 8) comprennent une première inductance (2), reliée à une première électrode (5) desdites électrodes de puissance (5, 6) et parcourue par ledit courant de puissance (i(t)), couplée magnétiquement négativement (k) à une seconde inductance (3), insérée en série entre ledit circuit de commande (7) et ladite électrode de commande (4), et fournissant à ses bornes ladite tension de mesure (V_{L2}),
une limitation de ladite dérivée temporelle est donnée par l'expression Vref/L1, où Vref est ladite tension de référence et L1 une valeur d'inductance de ladite première inductance (2), **caractérisé en ce que**
lesdits moyens de limitation (V_{L2}) comprennent en outre une source de tension (8) continue présentant une tension nominale (2 x Vd) prédéterminée insérée en série entre ledit circuit de commande (7) et ladite seconde inductance (3) de telle sorte que ladite tension de référence est égale à une somme de ladite tension de seuil et de ladite tension nominale (2 x Vd).

2. Dispositif de commande d'un transistor (1) en commutation selon la revendication précédente, **caractérisé en ce que** ladite source de tension (8) est formée par un nombre prédéterminé de diodes (9) identiques en série polarisées dans un sens direct par ledit circuit de commande (7) dans un état "haut", de telle sorte que ladite tension nominale (2 x Vd) est égale à une tension de coude (Vd) desdites diodes multipliée par ledit nombre.

3. Dispositif de commande d'un transistor (1) en commutation selon la revendication précédente, **caractérisé en ce que** lesdits moyens de limitation (2, 3, 8) comprennent en outre un condensateur (10) en parallèle sur lesdites diodes (9) et chargé dans un circuit de charge (7, 11, 12) comprenant au moins une résistance (11).

4. Dispositif de commande d'un transistor (1) en commutation selon la revendication précédente, **caractérisé en ce que** ladite première inductance (2) et ladite seconde inductance (3) constituent respectivement un primaire (2) et un secondaire (3) d'un transformateur planaire sans noyau magnétique formé au voisinage dudit transistor (1) dans une couche métallique d'un circuit imprimé ou sur un substrat de type DBC, IML, ou IMS.

5. Dispositif de commande d'un transistor (1) en commutation selon la revendication précédente, **caractérisé en ce qu'**un rapport de transformation dudit transformateur (2, 3) est supérieur ou égal à deux.

6. Dispositif de commande d'un transistor (1) en commutation selon l'une quelconque des revendications 1 à 5 précédentes, **caractérisé en ce que** ledit transistor (1) est de type MOSFET et **en ce que**:
- ladite électrode de commande (4) est une grille (G) dudit transistor (1);
- ladite première électrode (5) de puissance est une source (S) dudit transistor et une seconde électrode (6) desdites électrodes de puissance (5, 6) est un drain (D) dudit transistor (1).

7. Dispositif de commande d'un transistor (1) en commutation selon l'une quelconque des revendications 1 à 5 précédentes, **caractérisé en ce que** ledit transistor (1) est de type IGBT et **en ce que**:
- ladite électrode de commande (4) est une grille dudit transistor (1);
- ladite première électrode de puissance (5) est un émetteur dudit transistor (1) et une seconde électrode (6) desdites électrodes de puissance (5, 6) est un collecteur dudit transistor (1).

8. Utilisation du dispositif de commande selon l'une quelconque des revendications 1 à 7 précédentes dans un module de puissance de véhicule automobile comprenant au moins un transistor (1) en commutation.

## Patentansprüche

1. Vorrichtung zur Schaltsteuerung eines Transistors (1), die Folgendes beinhaltet:
- den Transistor (1), der eine Steuerelektrode (4) und Leistungselektroden (5, 6) umfasst;
- eine Steuerschaltung (7), die mit der Steuerelektrode (4) verbunden ist;
- Mittel zur Begrenzung (2, 3, 8) einer zeitlichen Ableitung eines Leistungsstroms (i(t)), der zwischen den Leistungselektroden (5, 6) fließt,
wobei die Begrenzungsmittel (2, 3, 8) eine Messspannung (V_{L2}), die zu der zeitlichen Ableitung proportional ist, gemäß einer vorgegebenen Referenzspannung nachführen, indem sie eine Fehlerspannung an die Steuerelektrode (4) anlegen, wobei die Fehlerspannung durch eine intrinsische Verstärkung des Transistors (1) im linearen Modus verstärkt wird, wobei die Referenzspannung größer als oder gleich einer Leitungsschwellenspannung des Transistors (1) ist,
wobei die Begrenzungsmittel (2, 3, 8) eine erste Induktivität (2) umfassen, die mit einer ersten Elektrode (5) der Leistungselektroden (5, 6) verbunden ist und von dem Leistungsstrom (i(t)) durchflossen wird und die mit einer zweiten Induktivität (3) negativ magnetisch (k) gekoppelt ist, welche zwischen der Steuerschaltung (7) und der Steuerelektrode (4) in Reihe geschaltet ist und an ihren Klemmen die Messspannung (V_{L2}) bereitstellt, wobei eine Begrenzung der zeitlichen Ableitung durch den Ausdruck Vref/L1 gegeben ist, wobei Vref die Referenzspannung und L1 ein Induktivitätswert der ersten Induktivität (2) ist, **dadurch gekennzeichnet, dass** die Begrenzungsmittel (V_{L2}) ferner eine Gleichspannungsquelle (8) beinhalten, die eine vorgegebene Nennspannung (2 x Vd) aufweist und zwischen der Steuerschaltung (7) und der zweiten Induktivität (3) in Reihe geschaltet ist, sodass die Referenzspannung gleich einer Summe aus der Schwellenspannung und der Nennspannung (2 x Vd) ist.

2. Vorrichtung zur Schaltsteuerung eines Transistors (1) nach dem vorhergehenden Anspruch, **dadurch gekennzeichnet, dass** die Spannungsquelle (8) durch eine vorgegebene Anzahl von identischen und in Reihe geschalteten Dioden (9) gebildet ist, die durch die Steuerschaltung (7) in einem "High"-Zustand vorwärts vorgespannt sind, sodass die Nennspannung (2 x Vd) gleich einer Kniepunktspannung (Vd) der Dioden multipliziert mit der Anzahl ist.

3. Vorrichtung zur Schaltsteuerung eines Transistors (1) nach dem vorhergehenden Anspruch, **dadurch gekennzeichnet, dass** die Begrenzungsmittel (2, 3, 8) ferner einen Kondensator (10) beinhalten, der zu den Dioden (9) parallel geschaltet ist und in einer Ladeschaltung (7, 11, 12) geladen wird, die mindestens einen Widerstand (11) beinhaltet.

4. Vorrichtung zur Schaltsteuerung eines Transistors (1) nach dem vorhergehenden Anspruch, **dadurch gekennzeichnet, dass** die erste Induktivität (2) und die zweite Induktivität (3) jeweils eine Primärspule (2) und eine Sekundärspule (3) eines Planartransformators ohne magnetischen Kern darstellen, der in der Nähe des Transistors (1) in einer Metallschicht einer gedruckten Schaltung oder auf einem Substrat vom Typ DBC, IML oder IMS gebildet ist.

5. Vorrichtung zur Schaltsteuerung eines Transistors (1) nach dem vorhergehenden Anspruch, **dadurch gekennzeichnet, dass** ein Transformationsverhältnis des Transformators (2, 3) größer als oder gleich zwei ist.

6. Vorrichtung zur Schaltsteuerung eines Transistors (1) nach einem der vorhergehenden Ansprüche 1 bis 5, **dadurch gekennzeichnet, dass** der Transistor (1) vom Typ MOSFET ist und dass:
- die Steuerelektrode (4) ein Gate (G) des Transistors (1) ist;
- die erste Leistungselektrode (5) eine Source (S) des Transistors ist und eine zweite Elektrode (6) der Leistungselektroden (5, 6) ein Drain (D) des Transistors (1) ist.

7. Vorrichtung zur Schaltsteuerung eines Transistors (1) nach einem der vorhergehenden Ansprüche 1 bis 5, **dadurch gekennzeichnet, dass** der Transistor (1) vom Typ IGBT ist und dass:
- die Steuerelektrode (4) ein Gate des Transistors (1) ist;
- die erste Leistungselektrode (5) ein Emitter des Transistors (1) ist und eine zweite Elektrode (6) der Leistungselektroden (5, 6) ein Kollektor des Transistors (1) ist.

8. Verwendung der Steuervorrichtung nach einem der vorhergehenden Ansprüche 1 bis 7 in einem Leistungsmodul eines Kraftfahrzeugs, das mindestens einen Schalttransistor (1) beinhaltet.

## Claims

1. Device for controlling switching of a transistor (1), comprising:
- said transistor (1), which comprises a control electrode (4) and power electrodes (5, 6);
- a control circuit (7) connected to said control electrode (4);
- means (2, 3, 8) for limiting a time derivative of a power current (i(t)) flowing between said power electrodes (5, 6),
said limiting means (2, 3, 8) automatically controlling a measurement voltage (V_{L2}) that is proportional to said time derivative to a preset reference voltage by applying an error voltage to said control electrode (4), said error voltage being amplified by an intrinsic gain of said transistor (1) in linear mode, said reference voltage being higher than or equal to a threshold voltage of conduction of said transistor (1),
said limiting means (2, 3, 8) comprising a first inductor (2) that is connected to a first electrode (5) of said power electrodes (5, 6) and passed through by said power current (i(t)), that is negatively magnetically coupled (k) to a second inductor (3), that is inserted in series between said control circuit (7) and said control electrode (4), and that delivers, across its terminals, said measurement voltage (V_{L2}),
a limitation of said time derivative being given by the expression Vref/L1, where Vref is said reference voltage and L1 is an inductance value of said first inductor (2), **characterized in that**
said limiting means (V_{L2}) further comprise a DC voltage source (8) having a preset nominal voltage (2×Vd) inserted in series between said control circuit (7) and said second inductor (3) such that said reference voltage is equal to a sum of said threshold voltage and of said nominal voltage (2×Vd).

2. Device for controlling switching of a transistor (1) according to the preceding claim, **characterized in that** said voltage source (8) is formed by a preset number of identical diodes (9) in series that are forward biased by said control circuit (7) to a "high" state, such that said nominal voltage (2×Vd) is equal to a knee voltage (Vd) of said diodes multiplied by said number.

3. Device for controlling switching of a transistor (1) according to the preceding claim, **characterized in that** said limiting means (2, 3, 8) further comprise a capacitor (10) in parallel with said diodes (9) and charged in a charging circuit (7, 11, 12) comprising at least one resistor (11).

4. Device for controlling switching of a transistor (1) according to the preceding claim, **characterized in that** said first inductor (2) and said second inductor (3) form a primary (2) and a secondary (3), respectively, of a planar core-less magnetic transformer formed in the vicinity of said transistor (1) in a metal layer of a printed circuit board or on a DBC, IML or IMS substrate.

5. Device for controlling switching of a transistor (1) according to the preceding claim, **characterized in that** a transformation ratio of said transformer (2, 3) is higher than or equal to two.

6. Device for controlling switching of a transistor (1) according to any one of Claims 1 to 5 above, **characterized in that** said transistor (1) is a MOSFET and **in that**:
- said control electrode (4) is a gate (G) of said transistor (1);
- said first power electrode (5) is a source (S) of said transistor and a second electrode (6) of said power electrodes (5, 6) is a drain (D) of said transistor (1).

7. Device for controlling switching of a transistor (1) according to any one of Claims 1 to 5 above, **characterized in that** said transistor (1) is an IGBT and **in that**:
- said control electrode (4) is a gate (G) of said transistor (1);
- said first power electrode (5) is an emitter of said transistor (1) and a second electrode (6) of said power electrodes (5, 6) is a collector of said transistor (1).

8. Use of the control device according to any one of Claims 1 to 7 above in a motor-vehicle power module comprising at least one switching transistor (1).
